# EUROPEAN PATENT APPLICATION

(11) **EP 2 249 233 A2**
(43) Date of publication of application: **10.11.2010**
(21) Application number: 10250887.6
(22) Date of filing: 06.05.2010
(51) Int. Cl.: G06F 3/041, G06F 3/042

(54) **Method and apparatus for recognizing touch operation**

(30) Priority: 06.05.2009 KR 20090039274
(71) Applicant: Samsung Mobile Display Co., Ltd., Yongin-city, Gyunggi-do 446-711 (KR)
(72) Inventor: Ku, Ja-Seung, Yongin-city, Gyunggi-do 446-711 (KR); Kim, Jae-Shin, Yongin-city, Gyunggi-do 446-711 (KR); Lee, Min-Jeung, Yongin-city, Gyunggi-do 446-711 (KR); Hwang, Hee-Chul, Yongin-city, Gyunggi-do 446-711 (KR)
(74) Representative: Mounteney, Simon James

(57) **Abstract**

A method for recognizing a touch of an object on a display device including optical sensors, the method including: detecting a touch of an object by utilizing a contact-detecting layer in the display device; generating an image of the touch of the object corresponding to sensor signals sensed by the optical sensors; detecting touch points corresponding to the image of the touch of the object; and determining information of the touch of the object based on the detected touch points.

## Description

### BACKGROUND

### 1. Field

The following description relates to a method and apparatus for recognizing a touch on a display device.

### 2. Description of the Related Art

In general, displays are used to show vivid images. However, recently, methods of conveying or acquiring information by directly touching an information medium with a user's hand have been applied to displays. For example, a touch panel display is a useful technology and is realized by various methods. Manufacturing technologies of liquid crystal display devices having integrated touch screen panels are being developed, and such touch-screen panel technology may be applied not only to the field of liquid crystal display panels, but also to various other types of displays. For example, the technology may be applied to the field of organic light-emitting diodes, which is considered one of the next generation display devices.

### SUMMARY OF THE INVENTION

The present invention sets out to provide a method and an apparatus for recognizing a touch on a display device, for precisely performing touch recognition in an optical type display device by determining whether a touch has been performed, using a contact-detecting layer.

According to an aspect of the present invention, there is provided a method for recognizing a touch of an object on a display device including optical sensors, the method including: detecting a touch of an object by utilizing a contact-detecting layer in the display device; controlling a sensor scanning unit to output sensor scan signals for driving the optical sensors when the touch of the object is detected; generating an image of the touch of the object corresponding to sensor signals sensed by the optical sensors; detecting touch points corresponding to the image of the touch of the object; and determining information of the touch of the object based on the detected touch points.

The controlling of the sensor scanning unit may include determining whether a signal corresponding to the touch of the object is greater than a value, wherein when the signal corresponding to the touch of the object is greater than the value, the sensor scanning unit outputs the sensor scan signals.

In the detecting of the touch points, the touch points may be detected in the image of the touch of the object, and coordinates of the touch points may be calculated.

The touch of the object may be a double click.

In the detecting of the touch points, two touch points may be detected in the image of the touch of the object, and coordinates of the two touch points may be calculated, and in the determining of the information of the touch of the object, a double click may be determined by calculating a time interval and a space interval between the two touch points.

The touch of the object may be determined to be a double click when the time interval is smaller than a first value and the space interval is smaller than a second value.

According to another aspect of another exemplary embodiment of the present invention, there is provided a method for recognizing a touch of an object on a display device including optical sensors, the method including: detecting a touch of an object by utilizing a contact-detecting layer in the display device; generating an image of the touch of the object corresponding to sensor signals sensed by the optical sensors; detecting touch points corresponding to the image of the touch of the object; performing preprocessing of the detected touch points corresponding to the detecting of the touch of the object; and determining information of the touch of the object based on the touch points after performing the preprocessing.

The performing the preprocessing of the detected touch points may include excluding some of the detected touch points based on a time when the touch of the object is detected.

The touch of the object may be a double click.

In the detecting of the touch points, at least two touch points may be detected in the image of the touch of the object, and coordinates of the at least two touch points may be calculated, and in the performing of the preprocessing, touch points that do not correspond to the time when the touch of the object is detected from among the at least two touch points may be excluded.

In the determining of the information of the touch of the object, a double click may be determined by calculating a time interval and a space interval of the at least two touch points after performing the preprocessing.

According to another aspect of the present invention, there is provided an apparatus for recognizing a touch of an object on a display device including optical sensors, the apparatus including: a touch sensing unit for sensing a touch of an object detected by a contact-detecting unit in the display device; a touch determining unit for controlling output of a sensor scan signal for driving the optical sensors when the touch of the object is detected; a touch point detecting unit for generating an image of the touch of the object corresponding to sensor signals sensed by the optical sensors, and for detecting touch points corresponding to the image of the touch of the object; and an action recognition unit for determining information of the touch of the object based on the detected touch points.

The touch determining unit may be configured to determine whether a signal output from the touch sensing unit is greater than a value, and to control the sensor scan signal to be output when the signal output from the touch sensing unit is greater than the value.

When the touch of the object is a double click, the touch point detecting unit may be configured to detect two touch points in the image of the touch of the object, and to calculate coordinates of the two touch points, and the action recognition unit may be configured to determine that the touch is a double click by calculating a time interval and a space interval between the two touch points.

The action recognition unit may include: a time determining unit for determining whether the time interval is smaller than a first value; a position determining unit for determining whether the space interval is smaller than a second value; and a double-click determining unit for determining whether a touch is a double click based on the determining of the time determining unit and the position determining unit.

According to another aspect of the present invention, there is provided an apparatus for recognizing a touch of an object on a display device including optical sensors, the apparatus including: a touch sensing unit for sensing a touch of an object detected by a contact-detecting unit in the display device; a touch point detecting unit for generating an image of the touch of the object corresponding to sensor signals sensed by the optical sensors, and for detecting touch points corresponding to the image of the touch of the object; a preprocessing unit for performing preprocessing of the detected touch points corresponding to the detecting of the touch of the object; and an action recognition unit for determining information of the touch of the object based on the touch points after performing the preprocessing.

The preprocessing unit may be configured to exclude some of the detected touch points based on a time when the touch of the object is detected.

According to another aspect of the present invention, there is provided a recording medium in which a program for implementing an above method in a computer may be recorded.

The above and other features of the invention are set out in the appended claims.

### BRIEF DESCRIPTION OF THE DRAWINGS

Embodiments of the invention will be described by way of example and with reference to the attached drawings in which:

FIG. 1 is a schematic diagram of a display device for inputting information on a screen by using optical signals according to an embodiment of the present invention;

FIG. 2 is a schematic diagram of a display device including a touch point detecting device according to another embodiment of the present invention;

FIG. 3 is a schematic diagram of a display device for inputting information on a screen by using optical signals according to another embodiment of the present invention;

FIG. 4 is a schematic block diagram of a touch recognition device according to another embodiment of the present invention;

FIG. 5 is a schematic block diagram of a touch recognition device according to another embodiment of the present invention;

FIGS. 6 through 8 are diagrams for describing double click recognition in a touch recognition device according to another embodiment of the present invention;

FIG. 9 is a schematic block diagram of an action recognition unit shown in FIGS. 4 and 5;

FIG. 10 is a flowchart for describing a method of recognizing a touch according to another embodiment of the present invention; and

FIG. 11 is a flowchart for describing a method of recognizing a touch according to another embodiment of the present invention.

### DETAILED DESCRIPTION

Hereinafter, embodiments of the present invention will be described in detail with reference to the attached drawings. In the drawings, elements having substantially similar functions are denoted by the same reference numerals. In addition, for convenience, an object touching a display device is illustrated as a finger in the descriptions, but the object is not limited to a finger.

In optical sensor type touch panel display devices, optical sensors are disposed in pixels, and information input on a screen is used to enable the sensors by using optical signals. In this type of display device, for example, photodiodes are used as the optical sensors, and a capacitor is connected to each photodiode to form a pixel. Charge in the capacitor varies with variations in the amount of received light of the photodiode, and data of detected images is produced by detecting varying voltages between the respective ends of the capacitors. A display device having a touch panel function or a digitizer function has been proposed. The touch panel inputs information by detecting shadows of an object such as a finger projected on a screen. In this case, input information is recognized by using various image recognition algorithms.

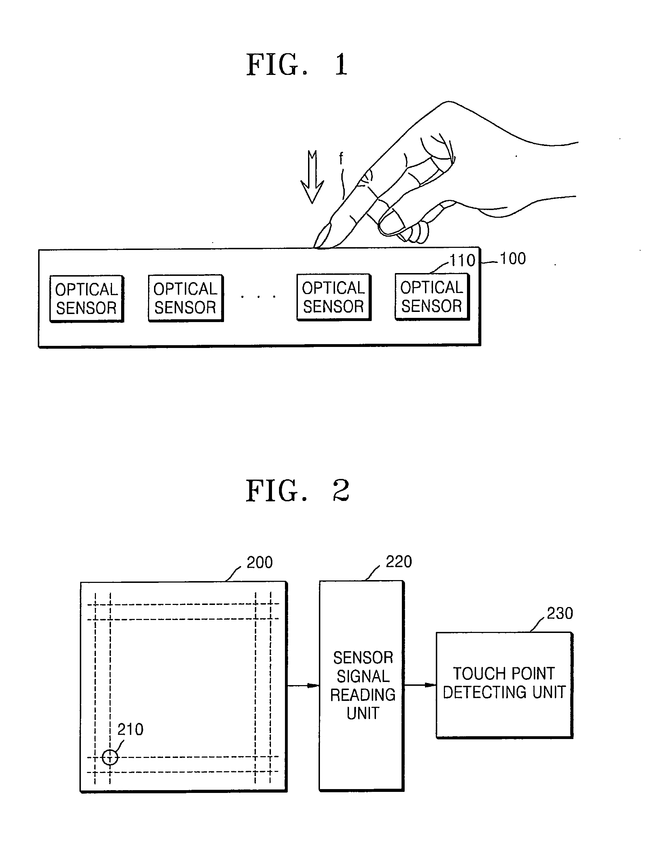

FIG. 1 is a schematic diagram of a display device for inputting information on a screen by using optical signals according to an embodiment of the present invention.

In FIG. 1, a display device 100 including a plurality of optical sensors 110 is shown.

The display device 100 includes optical sensors 110, and also a plurality of thin film transistors (TFTs) and various other display elements. For example, the display device 100 may include electrodes constituting the plurality of the TFTs, layers (semiconductor layers and dielectric layers) and organic light-emitting elements. The organic light-emitting elements may include a pixel electrode, another electrode facing the pixel electrode, and an intermediate layer including a light-emitting layer. The light-emitting layer may be interposed between the pixel electrode (e.g., an anode electrode) and the other electrode (e.g., a cathode electrode). In the embodiment of the present invention, the structure of the display device 100 senses a shadow of a finger F by ambient light, and also senses optical signals emitted from the organic light-emitting element and reflected from the finger F. In addition, although the organic light-emitting elements are specified as display elements in the present embodiment, embodiments of the present invention may include not only display devices using organic display elements, but may also include optical sensor type touch-screen display devices using other flat display elements, for example, liquid crystal displays (LCDs), plasma display panels (PDPs), or various other types of display devices.

When the display device 100 is touched by a particular object, for example a finger F, the optical sensors 110 detect optical signals due to the finger F being exposed to an external light source or an internal light source. For example, when the optical sensors 110 detect light brighter than a value (e.g., a predetermined value), a signal processing unit (not shown) outputs a high level signal, and when the optical sensors 110 detect light dimmer than a value (e.g., a predetermined value), the signal processing unit outputs a low level signal. The optical sensor 110 may be a PIN-type diode.

FIG. 2 is a schematic diagram of a display device including a touch point detecting unit 230 according to another embodiment of the present invention.

In FIG. 2, a display device 200 including optical sensors 210, a sensor-signal reading unit 220, and a touch point detecting unit 230, is shown.

The display device 200 includes red R, green G and blue B pixels disposed together with respective optical sensors 210 at regions where signal lines and scanning lines cross. The display device 200 displays images based on image signals transferred from, for example, an external host.

The sensor-signal reading unit 220 reads signals sensed by the optical sensors 210 of the display device 200, and outputs the read results to the touch point detecting unit 230.

The touch point detecting unit 230 interprets the signals sensed by the optical sensors 210 of the display device 200 and detects a touch point. In the embodiment of the present invention, the touch point detecting unit 230 forms finger shadow images according to the signals sensed by the optical sensors 210, and includes a signal processing unit for generating finger shadow images, for example, line memories, a gradation circuit, a binary coding circuit, or the like. In addition, the touch point detecting device 230 calculates a coordinate position of a finger touch by using a discrete image, an edge image, a gradation image, or the like. For example, when a difference image or an edge image is used, when an area of an image region is greater than a predetermined critical value, a weight center of the image region may be calculated as the coordinate position of a finger. In the present embodiment of the present invention, although coordinates of a touch point are calculated using the weight center of the image region of the finger, the present invention is not limited to this method, and it should be understood that coordinates of a touch point may be calculated using various other image interpreting methods.

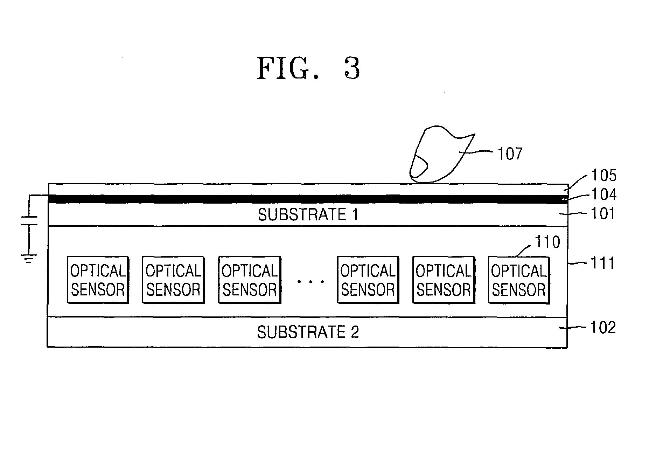

FIG. 3 is a schematic diagram of a display device having a function of inputting information on a screen by using optical signals according to another embodiment of the present invention. Here, the display device includes a contact-detecting layer for detecting whether or not a touch of an object, particularly a finger touch, is performed.

In FIG. 3, an optical sensor array layer 111 including a plurality of optical sensors 110, first and second substrates 101 and 102, a contact-detecting layer 104 and a dielectric layer 105, are shown.

The optical sensor array layer 111 is disposed on the second substrate 102. Between the first substrate 101 and the second substrate 102, the plurality of optical sensors 110, a plurality of TFTs, and various display elements may be additionally included. The first and second substrates 101 and 102 may be made of a glass material, a metallic material and/or a plastic material. In addition, in the present embodiment, although not shown in the optical sensor array layer 111, electrodes constituting the plurality of TFTs, layers (e.g., semiconductor layers and dielectric layers), and organic light-emitting elements may also be included in the optical sensor array layer 111.

The organic light-emitting element may include a pixel electrode, another electrode facing the pixel electrode, and an intermediate layer including a light-emitting layer. The light-emitting layer is interposed between the pixel electrode (e.g., an anode electrode) and the other electrode (e.g., a cathode electrode).

When a particular object, for example, a finger 107, contacts the display device, the optical sensors 110 calculate coordinates of the touch point by interpreting shadow images of the finger exposed to ambient light sources, interpret the amount of light to form a secondary image, interpret positional coordinates of the touch point from the secondary image, or interpret the amount of reflected light due to an internal light source to form a secondary image, and calculate positional coordinates of the touch point from the secondary image. The optical sensors 110 may be PIN-type optical diodes.

The contact-detecting layer 104 is disposed between the first substrate 101 and the dielectric layer 105. The contact-detecting layer 104 is composed of a transparent film to enhance a light transmission ratio, and therefore efficiency of the display elements is increased. In addition, the contact-detecting layer 104 may be integrated in a panel substrate during a panel manufacturing process, or may be additionally formed on the panel substrate. When a finger touches or contacts the contact-detecting layer 104, the contact-detecting layer 104 detects a capacitance variation due to the finger touch. In this case, the contact-detecting layer 104 and the panel form a capacitance. In the present embodiment, the display device is structured so that the contact-detecting layer 104 and the cathode electrodes disposed below the first substrate 101 may form capacitances. Here, the cathode electrodes are the cathode electrodes of the organic light-emitting elements included in the optical sensor array layer 111. Therefore, additional electrodes or layers are not necessary to form capacitances with the contact-detecting layer 104.

In the display device of the present embodiment having a function of inputting information on a screen by using optical signals, interpretation of an image obtained by the optical sensors 110, for example, complex image interpretation determining whether or not the screen is touched by an object, is performed by detecting edges of the object, inspecting moving directions of the detected edge images and determining that the screen is touched by the object when there are edge images moving in directions opposite to each other. However, since the contact-detecting layer 104 is disposed in the display device as described above, a touch can be recognized by detecting capacitance variation due to a finger contact by using the contact-detecting layer 104 without performing the complex image interpretation. In addition, the optical sensors 110 may separately perform an operation of calculating coordinates of a contact position. Here, when the value of capacitance detected by using the contact-detecting layer 104 is greater or smaller than a capacitance value (e.g., a preset critical capacitance value), a host or a contact-determining module (not shown) may be programmed to determine that a finger or other object has touched the screen. In addition, the coordinate calculation load of the optical sensors 110 may be reduced by selectively using finger touch information detected by the contact-detecting layer 104 in conjunction with a contact position calculation of the optical sensors 110.

A conventional display device having a function of inputting information on a screen by using optical signals detects edges of an object from a photographed image and determines whether or not an object touches the screen by using the detected edges. At this time, the display device inspects moving directions of the edges, and determines that the object touches the screen when there are edges moving in directions opposite to each other. Then, when it is determined that the object touches the screen, the display device finds out the weight center of the detected edges and calculates a coordinate position of a touch position. However, in the embodiment of the present invention, since whether or not an object, particularly, a finger, touches the screen is detected by using the contact-detecting layer 104, which is simpler than the above-described conventional image processing method, the amount of calculation performed by a central processing unit (CPU) and the load on memory may be reduced. In addition, an error in recognition due to a shadow of a finger, rather than an actual finger touch, which may occur in a conventional image analysis method, may be prevented or reduced.

The dielectric layer 105 is formed on the contact-detecting layer 104, and has a function of blocking or reflecting ambient light so as to reduce or minimize it from reaching the light-emitting elements or the optical sensors 110. The dielectric layer 105 may be excluded from the structure of the display device in some embodiments.

Although, in this embodiment of the present invention, the contact-detecting layer 104 is disposed between the first substrate 101 and the dielectric layer 105, and a touch is determined by a capacitance measuring method, the number and disposition of the contact-detecting layer 104 may vary. For example, a touch may be determined by detecting variations in dielectric permittivity due to a pressure from the touch.

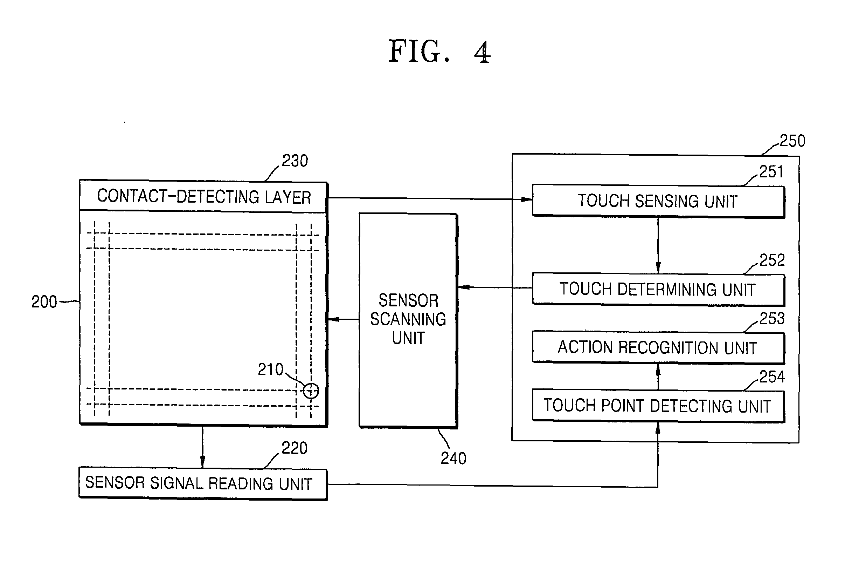

FIG. 4 is a schematic block diagram of a touch recognition device 250 according to another embodiment of the present invention.

In FIG. 4, a display panel 200 including a plurality of optical sensors 210, a contact-detecting layer 230 installed in the display panel 200 or attached to the display panel 200, a sensor scanning unit 240 for providing scanned signals to the optical sensors 210, a sensor signal reading unit 220 for reading data obtained by the optical sensors 210, and a touch recognition device 250 are shown. Here, the touch recognition device 250 includes a touch sensing unit 251, a touch determining unit 252, a touch point detecting unit 254, and an action recognition unit 253.

When a particular object, for example, a finger, contacts the optical sensors 210, the optical sensors 210 calculate coordinates of the touch point by interpreting shadow images of the finger exposed to ambient light sources, interpret the amount of light to form a secondary image, interpret positional coordinates of the touch point from the secondary image, or interpret the amount of reflected light due to an internal light source to form a secondary image and calculate positional coordinates of the touch point from the secondary image. The display panel 200 includes red R, green G and blue B pixels disposed together with respective optical sensors 210 at regions where signal lines and scanning lines cross. The display panel 200 displays images based on image signals transferred from an external host.

The contact-detecting layer 230 detects whether or not a particular object, for example, a finger, touches a display screen, and outputs the detected touch information to the touch recognition device 250. According to the above-described embodiments of the present invention, such touch information includes amounts of capacitance variation.

When the touch determining unit 252 determines that a finger touches the display screen, the sensor scanning unit 240 outputs scan signals to the display panel 200 to select or activate the optical sensors 210. The sensor signal reading unit 220 reads signals sensed by the optical sensors 210 of the display panel 200 and outputs the read signal to the touch point detecting unit 254.

The signals sensed by the optical sensors 210 are input to the touch point detecting unit 254 via the sensor signal reading unit 220 to calculate positional coordinates of the touched point, and outputs the calculated result to the action recognition unit 253.

Touch information from the contact-detecting layer 230 is input to the touch sensing unit 251, and the touch sensing unit 251 measures the amount of variation in the touch information. The touch sensing unit 251 measures the amount of variation in touch information due to a finger touch or contact, that is, the amount of capacitance variation due to a touch.

The amount of variation in touch information from the touch sensing unit 251 is input to the touch determining unit 252, and the touch determining unit 252 compares the amount of variation in touch information with a preset reference value to determine whether or not the display screen is touched or contacted by an object. Such a reference value is a value that may be provided by a host and stored in advance in the touch determining unit 252. In more detail, the touch determining unit 252 determines that a touch is performed when the values of capacitance measured in the touch sensing unit 251 increase at a specific rate as compared with the stored reference capacitance value. In particular, when the touch determining unit 252 determines that a touch is performed, the touch determining unit 252 controls the sensor scanning unit 240 to output sensor scan signals to the display panel 200 to select or activate the optical sensors 210. Here, the sensor scan signals may be low level signals or high level signals.

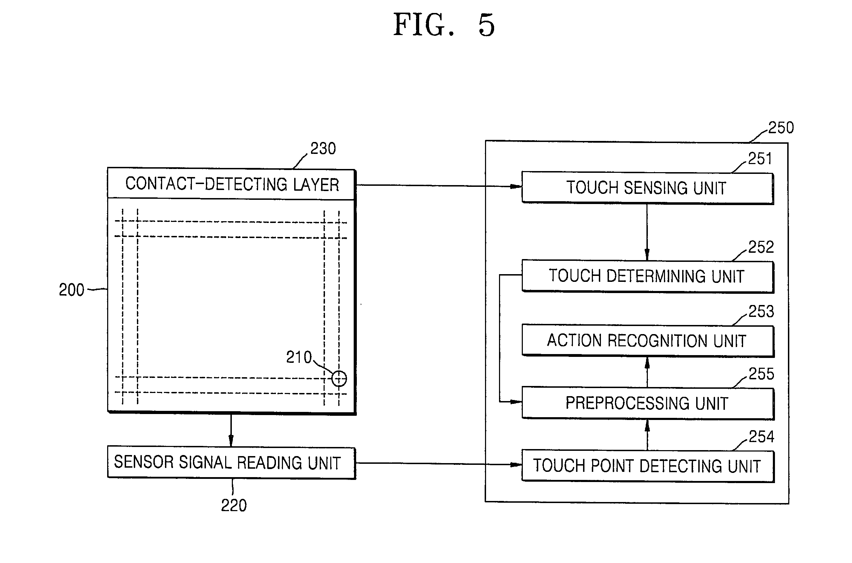

FIG. 5 is a schematic block diagram of a touch recognition device according to another embodiment of the present invention.

In FIG. 5, a display panel 200 including a plurality of optical sensors 210, a contact-detecting layer 230 installed in the display panel 200 or attached to the display panel 200, a sensor signal reading unit 220 for reading data obtained by the optical sensors 210, and a touch recognition device 250 are shown. Here, the touch recognition device 250 includes a touch sensing unit 251, a touch determining unit 252, a touch point detecting unit 254, a preprocessing unit 255, and an action recognition unit 253.

Here, the preprocessing unit 255 excludes touch points detected by the touch point detecting unit 254 in accordance with time information of when an object, particularly, a finger, touches the display screen. Here, the point of time when the finger touches the display screen includes time information corresponding to when the touch determining unit 252 determines that the finger touched the display screen. Therefore, the preprocessing unit 255 excludes touch points detected before and/or after the time information from the plurality of the touch points detected by the touch point detecting unit 254, by utilizing the time information provided by the touch determining unit 252. Therefore, the action recognition unit 253 recognizes touches based only on the touch points touched at the time when the actual touch was performed.

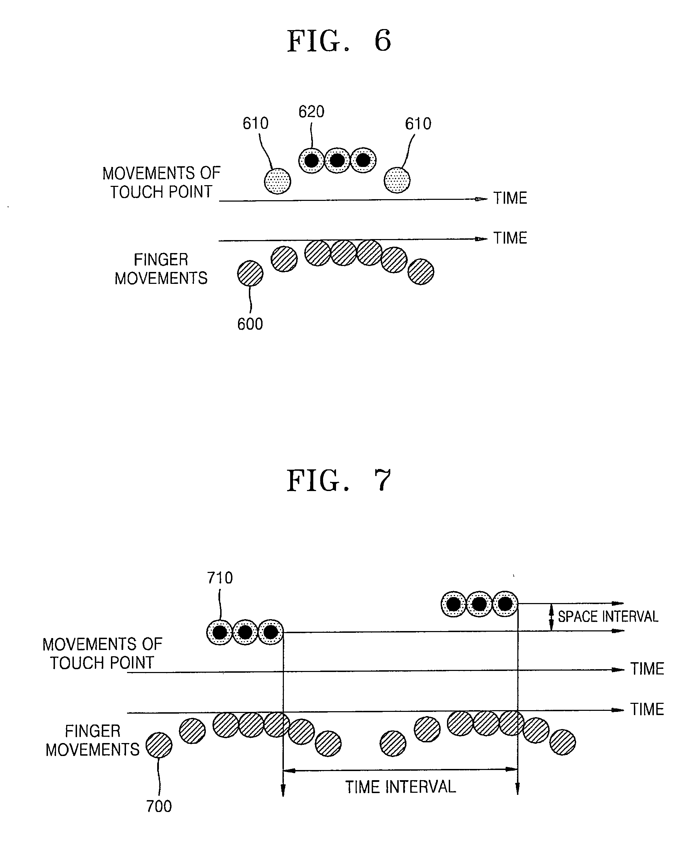

FIGS. 6 through 8 are diagrams for describing double click recognition in a touch recognition device according to another embodiment of the present invention.

When optical sensors detect shadowed points with respect to a finger shadow, the optical sensors may detect shadowed points before a finger actually touches the panel. In FIG. 6, finger movements 600 during a time interval in which the finger touches the panel, and movements 610 and 620 of detected touch points are shown. The finger movements 600 are shown according to distances between the finger and the panel, and the movements 610 and 620 of the touch points are shown according to the positions of touch points detected and/or selected by the optical sensor. However, only the movements 620 are points where the panel is actually touched.

Referring to FIG. 6, among the finger movements 600, the third, fourth, and fifth hatched circles (from the left in FIG. 6) represent points where the finger actually touches the panel, and the first, second, sixth, and seventh hatched circles represent where the finger does not actually touch the panel. In this case, among the movements 610 and 620 of the detected touch points, only the movements 620 should be detected as touch points. However, since the points in the movements 610 are also detected as touch points, there is a problem in that a touch may be unintentionally detected.

Generally, a user uses an index finger to implement a double click (e.g., two successive touches in a space within a certain period of time). A user's action is illustrated in, for example, FIG. 7.

In FIG. 7, movements 700 of, for example, an index finger, and movements 710 of touch points that were detected are shown. According to the embodiment of the present invention, since the touch determining unit controls the sensor scanning unit to output sensor scan signals to the display panel to select or activate the optical sensors (e.g., when the contact-detecting layer determines that the finger actually touches the screen), only the two touch points when the finger actually touches the screen are detected.

Therefore, the panel device may precisely determine whether or not a click is a double click according to a time interval and a space interval between touch points in the movements 710.

To reduce or minimize occurrence of touch points being selected before a finger touches a panel in a display device having optical sensors, the embodiment of the present invention employing a contact-detecting layer does not select points from finger shadows before an actual touch is detected, since whether or not an actual touch is performed is determined using the contact-detecting layer.

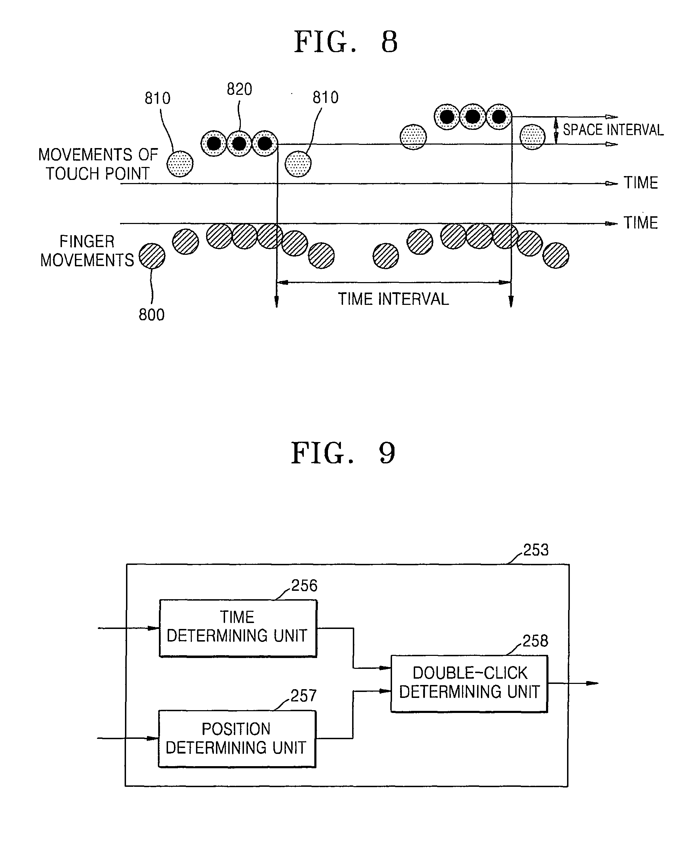

With reference to FIG. 8, a method of excluding touch points that occur before a finger touches the panel to determine an actual touch will be described.

Among touch points detected according to movements 800 of, for example, an index finger to implement a double click, points 810 that are not actual touch points should be excluded. Therefore, in the embodiment of the present invention, the contact-detecting layer determines whether or not an actual touch is performed, and performs preprocessing to exclude particular touch points according to determined time information. Here, the number of touch points 810 to be excluded are set variously according to preprocessing. According to the above procedures, the display device recognizes a touch, finds a touch position and a touch time, and recognizes a click as a double click when the position and time intervals are within respective values or ranges (e.g., predetermined values or ranges).

FIG. 9 is a schematic block diagram of an action recognition unit 253 shown in FIGS. 4 and 5.

Referring to FIG. 9, the action recognition unit 253 includes a time determining unit 256, a position determining unit 257, and a double-click determining unit 258.

The time determining unit 256 determines whether or not a time interval between two touch points is smaller than a value (e.g., a predetermined critical value). Here, the value may be set arbitrarily. Examples of time intervals are shown in FIGS. 7 and 8.

The position determining unit 257 determines whether or not a space interval between two touch points is smaller than a value (e.g., a predetermined critical value). Here, the value may be set arbitrarily. Examples of space intervals are also shown in FIGS. 7 and 8.

The double-click determining unit 258 determines whether or not a touch is a double click based on the determined results of the time determining unit 256 and the position determining unit 257. That is, when both the time interval and the space interval are smaller than the above described values, the double-click determining unit 258 determines that the click is a double click.

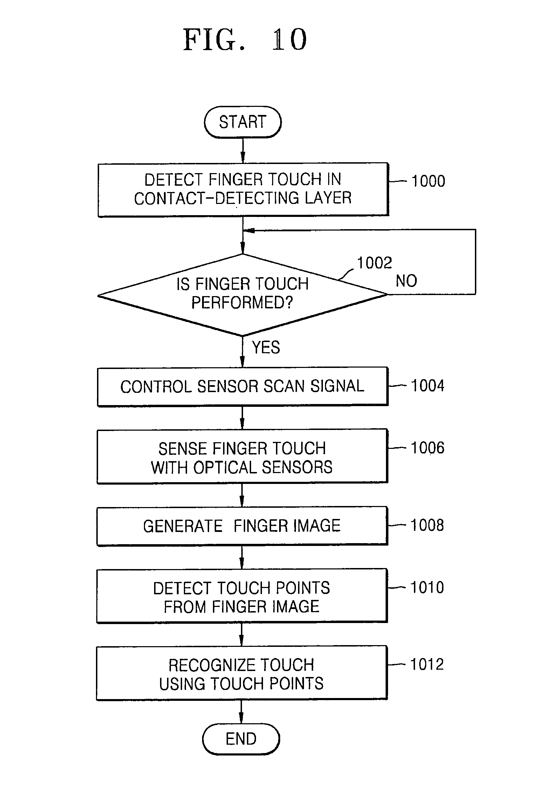

FIG. 10 is a flowchart for describing a method of recognizing a touch according to another embodiment of the present invention.

Referring to FIG. 10, a contact-detecting layer detects a finger touch 1000. A touch determining unit determines whether or not a finger touch is performed in operation 1002. Here, determining whether or not a finger touch is performed is accomplished by determining whether or not a touch sensing signal, for example, amount of capacitance variation, is greater than a value (e.g., a predetermined critical value). When an actual touch is performed and determined in the result of operation 1002, the display device controls a sensor scan signal to be output in operation 1004. According to the sensor scan signal the optical sensors senses a finger touch in operation 1006. The display device forms a finger image according to the sensor signals read from the optical sensors in operation 1008. Touch points are detected from the finger image through image interpretation in operation 1010. The touch is recognized using the touch points in operation 1012.

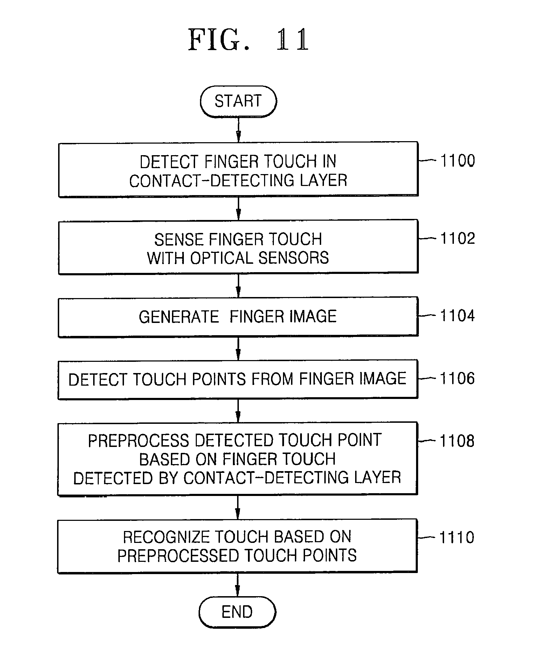

FIG. 11 is a flowchart for describing a method of recognizing a touch according to another embodiment of the present invention.

Referring to FIG. 11, a contact-detecting layer detects a finger touch in operation 1100. The optical sensors sense the finger touch in operation 1102. Here, operations 1102 and 1100 may be performed together. A finger image is formed by reading sensor signals sensed by the optical sensors in operation 1104. Touch points are detected from the finger image 1106. The touch points detected in operation 1106 are preprocessed based on the finger touch time sensed in operations 1100 to 1108. Here, the preprocessing means an operation of excluding touch points detected before and/or after the touch time among the touch points detected in operation 1106. The touch is recognized based on the preprocessed touch points in operation 1110.

In embodiments of the present invention, touch recognition may be more precisely performed in an optical sensor type display device by determining whether or not a touch is performed using a contact-detecting layer provided in a display device according an embodiment of the present invention.

In addition, since shadows before a finger actually touches a screen are not determined to be touch points, a touch may be more precisely represented.

In addition, embodiments of the present invention may be implemented as code that may be read by a computer (e.g., on a recording medium that may be read by a computer). The recording medium may be any kind of recording apparatus for storing data to be read by a computer system.

Examples of recording mediums that may be read by a computer are a ROM, a RAM, a CD-ROM, a magnetic tape, a floppy disk, an optical data storage device, and the like. In addition, the recording medium may include a recording method implemented by, for example, transmission through the Internet. In addition, the recording mediums may be distributed to computer systems connected in a network, and code that may be read by a computer may be stored and executed in a distributed manner. In addition, functional programs, codes, and code segments for implementing embodiments of the present invention may be easily created by programmers of ordinary skill in the art.

While the present invention has been particularly shown and described with reference to embodiments thereof, it will be understood by those of ordinary skill in the art that various changes in form and details may be made therein without departing from the scope of the present invention as defined by the following claims.

## Claims

1. A method for recognizing a touch of an object on a display device comprising optical sensors, the method comprising:
detecting a touch of an object by utilizing a contact-detecting layer in the display device;
generating an image of the touch of the object corresponding to sensor signals sensed by the optical sensors;
detecting touch points corresponding to the image of the touch of the object;
and
determining information of the touch of the object based on the detected touch points.

2. A method according to Claim 1, comprising controlling a sensor scanning unit to output sensor scan signals for driving the optical sensors when the touch of the object is detected.

3. A method according to claim 1, wherein the controlling of the sensor scanning unit comprises determining whether a signal corresponding to the touch of the object is greater than a value, wherein when the signal corresponding to the touch of the object is greater than the value, the sensor scanning unit outputs the sensor scan signals.

4. A method according to Claim 1, comprising performing preprocessing of the detected touch points corresponding to the detecting of the touch of the object,
wherein the performing the preprocessing of the detected touch points comprises excluding some of the detected touch points based on a time when the touch of the object is detected.

5. A method according to any preceding claim, wherein in the detecting of the touch points, the touch points are detected in the image of the touch of the object, and coordinates of the touch points are calculated.

6. A method according to any preceding claim, wherein the touch of the object is a double click.

7. A method according to claim 6 when dependent upon one of claims 1 to 3, wherein in the detecting of the touch points, two touch points are detected in the image of the touch of the object, and coordinates of the two touch points are calculated, and wherein in the determining of the information of the touch of the object, a double click is determined by calculating a time interval and a space interval between the two touch points.

8. A method according to claim 7 when dependent upon claim 4, wherein in the detecting of the touch points, at least two touch points are detected in the image of the touch of the object, and coordinates of the at least two touch points are calculated, and wherein in the performing of the preprocessing, touch points that do not correspond to the time when the touch of the object is detected from among the at least two touch points are excluded,
wherein in the determining of the information of the touch of the object, a double click is determined by calculating a time interval and a space interval of the at least two touch points after performing the preprocessing.

9. A method according to claim 7 or 8, wherein the touch of the object is determined to be a double click when the time interval is smaller than a first value and the space interval is smaller than a second value.

10. An apparatus for recognizing a touch of an object on a display device comprising optical sensors, the apparatus comprising:
a touch sensing unit for sensing a touch of an object detected by a contact-detecting unit in the display device;
a touch point detecting unit for generating an image of the touch of the object corresponding to sensor signals sensed by the optical sensors, and for detecting touch points corresponding to the image of the touch of the object; and
an action recognition unit for determining information of the touch of the object based on the detected touch points.

11. An apparatus according to claim 10, comprising a touch determining unit for controlling output of a sensor scan signal for driving the optical sensors when the touch of the object is detected.

12. Apparatus according to claim 11, wherein the touch determining unit is configured to determine whether a signal output from the touch sensing unit is greater than a value, and to control the sensor scan signal to be output when the signal output from the touch sensing unit is greater than the value.

13. Apparatus according to claim 10, comprising a preprocessing unit for performing preprocessing of the detected touch points corresponding to the detecting of the touch of the object,
wherein the preprocessing unit is configured to exclude some of the detected touch points based on a time when the touch of the object is detected.

14. Apparatus according to one of claims 10 to 13, wherein when the touch of the object is a double click, the touch point detecting unit is configured to detect two touch points in the image of the touch of the object, and to calculate coordinates of the two touch points, and the action recognition unit is configured to determine that the touch is a double click by calculating a time interval and a space interval between the two touch points.

15. Apparatus according to claim 14, wherein the action recognition unit comprises:
a time determining unit for determining whether the time interval is smaller than a first value;
a position determining unit for determining whether the space interval is smaller than a second value; and
a double-click determining unit for determining whether a touch is a double click based on the determining of the time determining unit and the position determining unit.
